# EUROPEAN PATENT APPLICATION

(11) **EP 4 549 372 A1**
(43) Date of publication of application: **07.05.2025**
(21) Application number: 24209213.8
(22) Date of filing: 28.10.2024
(51) Int. Cl.: B81B 7/00

(54) **MICRO-ELECTRO-MECHANICAL DEVICE HAVING CONTACT PADS THAT ARE PROTECTED AGAINST HUMIDITY AND MANUFACTURING PROCESS THEREOF**

(30) Priority: 03.11.2023 IT 202300023175
(71) Applicant: STMicroelectronics International N.V., 1228 Plan-les-Ouates, Geneva (CH)
(72) Inventor: CORSO, Lorenzo, 20871 RUGINELLO (MB) (IT); VERCESI, Federico, 20134 MILANO (IT); GATTERE, Gabriele, 21040 CASTRONNO (VA) (IT); GUERRA, Anna, 24048 TREVIOLO (BG) (IT); VALZASINA, Carlo, 20060 GESSATE (MI) (IT); ALLEGATO, Giorgio, 20900 MONZA (MB) (IT)
(74) Representative: Studio Torta S.p.A.

(57) **Abstract**

MEMS device (50) having a substrate (52) of semiconductor material; a first structural layer (54) of semiconductor material, on the substrate (52); a second structural layer (55) of semiconductor material, on the first structural layer (54); an active portion (83), accommodating active structures (85, 86) formed in the first structural layer (54) and/or in the second structural layer (55); a connection portion (56), accommodating a plurality of connection structures (57) and arranged laterally to the active portion (85, 86); and a plurality of conductive regions (60), arranged on the substrate (52) and extending between the active portion (85, 86) and the connection portion (56). Each connection structure (57) is formed by a first connection portion (57A), in electrical contact with a respective conductive region (60A) and formed in the first structural layer (54), and by a second connection portion (57B), on the first connection portion (57A) and in electrical continuity therewith, the second connection portion (57) formed in the second structural layer (55). The first connection portion (57A) has a greater thickness than the second connection portion (57B).

## Description

### Technical Field

The present invention relates to a micro-electromechanical device having contact pads protected against humidity and to the manufacturing process thereof.

In particular, the considered inertial MEMS device comprises one or more inertial sensors, such as an accelerometer and/or a gyroscope, formed in at least one silicon structural layer and defining at least one movable structure. The movable structure generally has main extension in an extension plane and is movable in-plane or out-of-plane.

### Background

As known, inertial-type MEMS devices of this type are increasingly used in consumer, automotive and industrial applications, they often integrate two or more inertial sensors in a same die and are packaged together with the related control circuits, generally formed in a separate die and forming an ASIC (Application Specific Integrated Circuit).

These devices are connected to the outside (for example to the ASIC and/or other external devices) through contact pads.

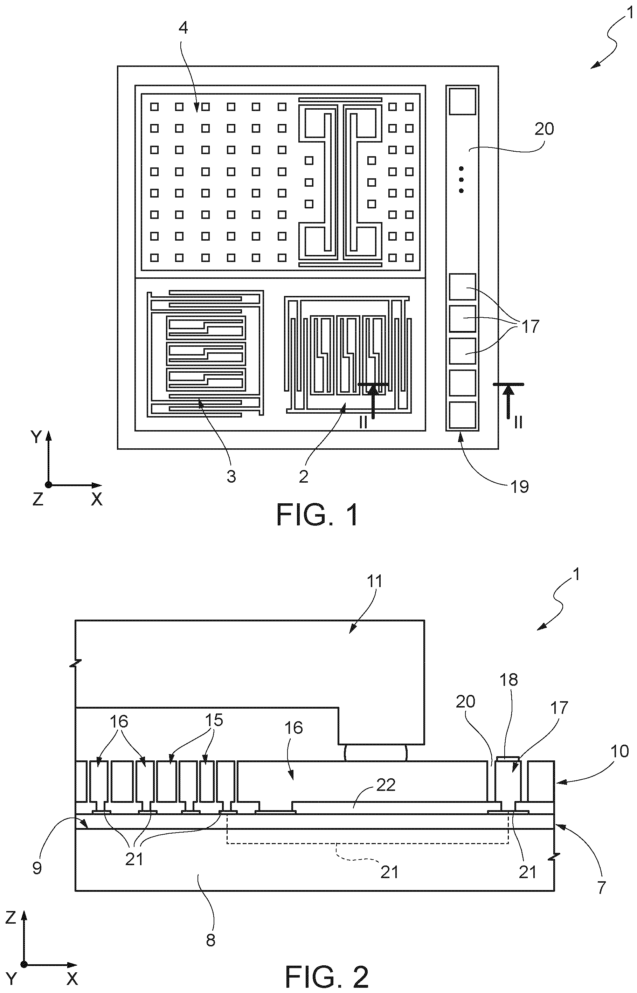

Figure 1 shows, for example, an inertial-type MEMS device (hereinafter referred to as inertial device 1) forming a triaxial accelerometer, of capacitive type.

The inertial device 1 comprises a first sensitive portion 2, a second sensitive portion 3 and a third sensitive portion 4. The sensitive portions 2-4 include movable structures having a substantially planar extension, parallel to an XY plane of a Cartesian reference system XYZ.

In particular, in the shown inertial device 1, the first sensitive portion 2 is intended for detecting oscillations along a first horizontal axis X of the Cartesian reference system XYZ; the second sensitive portion 3 is intended for detecting oscillations along a second horizontal axis Y of the Cartesian reference system XYZ; and the third sensitive portion 4 is intended for detecting oscillations along a vertical axis Z of the Cartesian reference system XYZ.

For example, as shown in the enlarged detail of Figure 2, the inertial MEMS device 2 may be formed in a die 7 of semiconductor material, comprising a substrate 8, for example of monocrystalline silicon; an insulating layer 9, superimposed on the substrate 7, for example of silicon oxide; a structural layer 10, superimposed on the insulating layer 9, for example of mono- or polycrystalline silicon; and a cap 11, for example of monocrystalline silicon, superimposed and attached to the structural layer 10.

The structural layer 10 forms movable structures 15 (for example suspended masses and movable electrodes of the sensitive portions 2-4) and fixed structures 16 (for example fixed electrodes of the sensitive portions 2-4, a peripheral fixed structure and anchoring regions of the movable structures).

The movable structures 15 are suspended, at a distance, above the substrate 8 and the insulating layer 9 and extend at a distance from the cap 11 to be able to move freely or in a limited manner.

The structural layer 10 also forms connection structures 17 in a connection portion 19 (Figure 1). The connection structures 17 (see also Figure 2) are here columnar in shape, separated from each other and from the rest of the structural layer 10 by a trench 20, here shown empty, but which might be filled with material and layers that are at least partially insulating, so as to allow the electrical insulation thereof.

A soldering layer 18, typically of metal such as aluminum Al, gold Au, copper Cu or aluminum-copper AlCu, extends on each connection structure 17.

Conductive tracks 21, for example of doped polycrystalline silicon, extend above the insulating layer 9, between the fixed structures 16 and respective connection structures 17, for biasing the movable 15 and fixed structures 16 and for exchanging signals.

Further conductive tracks (not shown) may extend, at least in part, also on the structural layer 10, possibly electrically insulated therefrom by a dielectric layer, also not shown.

Figure 2 further shows insulation regions 22 extending on the insulating layer 9, here in a peripheral region of the inertial device 1.

After mounting on a connection support, for example a printed circuit board, and connecting the connection structures 17 to the external devices, lines and connectors, for example through wires not shown, the inertial device 1 is generally packaged in a protection housing, of insulating material, such as resin, in particular when they are intended to work in harsh environments.

However, the resin packages commonly used for the considered inertial devices are not completely hermetic and may allow passage of humidity, for example in presence of elaborate geometries and in proximity to the connection structures 17. However, the presence of humidity may affect the electrical characteristics of the devices and, above all, determine a variation thereof over time (drift phenomenon) which impacts the reliability of the inertial devices.

In fact, for example in accelerometers and in gyroscopes, the capacitances between the connection structures 17, in particular between the structures connected to the movable masses (rotors) and the detection electrodes, affect the offset of the inertial device.

In these devices, these passive capacitances are calibrated during final test steps and the device parameters are trimmed to take into account the initial conditions.

However, the current geometry and dimensions of the connection structures 17, in particular when manufactured using polycrystalline silicon deposition processes on sacrificial regions that are removed after the definition of the mechanical and electrical structures of the sensor, may cause penetration of humidity droplets during operation and considerably modify the electrical characteristics of the devices over time.

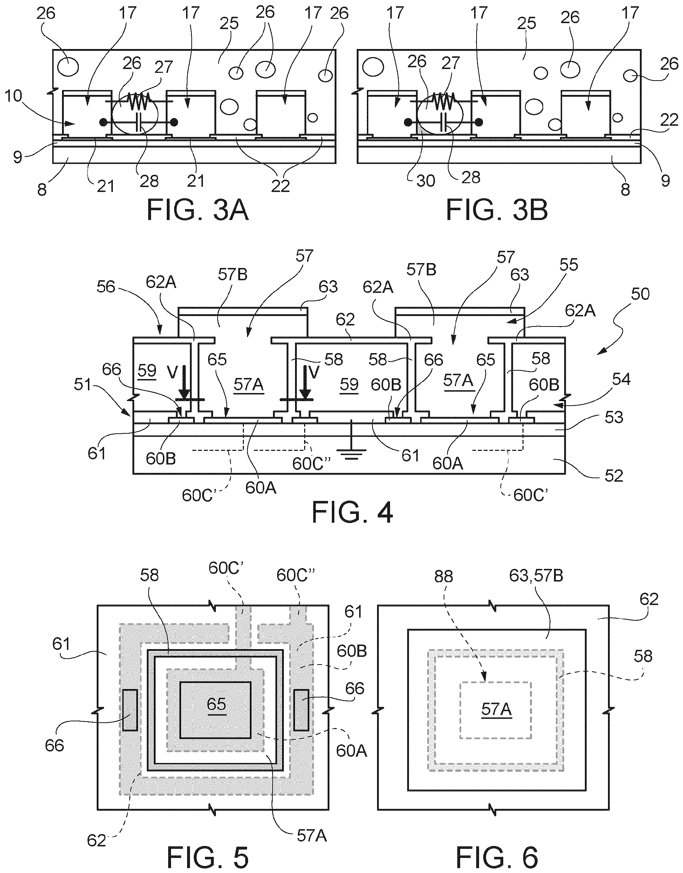

For further understanding, reference be made to Figure 3A, showing a section of the inertial device 1 in the zone of the connection structures 17, through the same.

Figure 3A also shows the packaging material, also called filler and indicated by 25, which covers the surface of the inertial device 1 and extends between the connection structures 17. Due to the current dimensions of the current structures (with structural layer 10 having a thickness of even 30 pm), the packaging material 25 may incorporate air or gas bubbles, indicated by 26 in Figure 3A. The air bubbles 26 prevent the filling material from completely filling the spaces between the connection structures 17 and may affect the resistivity and the capacitance between the connection structures 17, as represented schematically in Figure 3A by a resistance 27 and a capacitance 28.

As indicated, in the final test step, the inertial device 1 is calibrated so as to take into consideration the value of the resistance 27 and the capacitance 28.

However, during the life of the device, when exposed to humidity, tiny water droplets may penetrate inside the packaging material 25, which is not hermetic, and modify the capacitance between two connection structures 17.

For example, Figure 3B shows the presence of a water droplet 30 in contact with a connection structure 17.

The presence of water droplets 30 in the space between the connection structures 17 not only modifies the capacitance between the same connection structures 17, but may lead to catastrophic conditions for the device.

In fact, water drops may short-circuit two adjacent connection structures 17, especially in current devices wherein the structures are increasingly smaller and closer, and/or may cause current leakage, especially if they reach the conductive tracks 21.

Since water drops cannot escape, this condition may only worsen over time, making inertial devices unreliable or even unusable.

To overcome this issue, passivation structures may be created that completely surround the connection structures 17, for example by forming separate trenches that surround the individual connection structures 17, coating the trenches with a dielectric layer (for example a silicon oxide) and filling them with silicon. However, this solution entails an increase in the area necessary for the connection structures 17, which clashes with the current trend to miniaturization.

Alternatively, in the final manufacturing step, different connection structures may be studied, with removal of the columnar regions formed in the structural layer, but this solution entails, in addition to additional manufacturing steps, lower flexibility in the design; therefore this solution is not always usable.

DE102012200655B4 discloses a MEMS device having contact base formed by lower portions and upper portions that are mutually each other by trenches and protected at the top by an oxide layer.

The aim of the present invention is to overcome the problem indicated above.

### Summary

According to the present invention, a MEMS device, a packaged device and a manufacturing process of a MEMS device are provided, as defined in the attached claims.

In practice, a MEMS device is provided comprising:
a substrate of semiconductor material;
a first structural layer of semiconductor material, superimposed on the substrate and having a first thickness;
a second structural layer of semiconductor material, superimposed on the first structural layer and having a second thickness;
an active portion, accommodating active structures formed in the first structural layer and/or in the second structural layer;
a connection portion, accommodating a plurality of connection structures and arranged laterally to the active portion; and
a plurality of conductive regions, arranged above the substrate and extending between the active portion and the connection portion,
wherein each connection structure comprises:
   a first connection portion, in electrical contact with a respective conductive region of the plurality of conductive regions and formed in the first structural layer; and
   a second connection portion, on the first connection portion and in electrical continuity therewith, the second connection portion formed in the second structural layer;
   the first connection portion having a greater thickness than the second connection portion.

Thereby, the second connection portions of the connection structures may have a reduced height compared to prior art, so that it is less likely that air or gas bubbles, even of large dimensions, may touch two adjacent connection structures.

In addition, any humidity that penetrates and infiltrates under any bubble that forms between two second connection portions cannot reach the conductive regions due to the height of the first connection portions.

Furthermore, the lower height of the second connection portions with respect to the first connection portions of the connection structures causes the facing area of the second connection portions to be small, reducing the risk of electrical connection between adjacent second connection portions in case of humidity.

### Brief Description of the Drawings

For a better understanding of the present invention, embodiments thereof are now described, purely by way of nonlimiting example, with reference to the attached drawings, wherein:
- Figure 1 is a top-plan view of a possible layout of an inertial MEMS device;
- Figure 2 is a cross-sectional view of a portion of the device of Figure 1, in the zone of the connection structures, taken along section line II-II of Figure 1;
- Figures 3A and 3B show an enlarged detail of the zone of the connection structures of Figure 2, in presence of air bubbles and, respectively, water droplets;
- Figure 4 is a cross-sectional view of the present microelectromechanical device in the zone of the connection structures;
- Figure 5 is a cross-section taken along line V-V of Figure 4, illustrating the shape of a lower portion of a connection structure;
- Figure 6 is a top view of one of the connection structures of Figure 4;
- Figure 7 is a top view of the zone of the connection structures of the microelectromechanical device of Figure 4;
- Figure 8 is an enlarged cross-section of two connection structures of the microelectromechanical device of Figure 4, after packaging;
- Figures 9-12 are cross-sections, similar to Figure 8, of a semiconductor wafer during successive manufacturing steps; and
- Figure 13 shows a cross-section of an embodiment of the present microelectromechanical device.

### Description of Embodiments

The following description refers to the arrangement shown; consequently, expressions such as "above", "below", "upper", "lower", "right", "left" relate to the attached figures and should not be interpreted in a limiting manner.

Figure 4 shows a portion of a MEMS device 50. The MEMS device 50 is a generic device, for example the inertial device 1 of Figure 1.

The MEMS device 50 is a device made using two polycrystalline silicon layers and sacrificial material regions used for defining the device structures and selectively removed so as to free the movable structures, as described in Italian patent 102020000011755, filed on 5/20/2020 in the name of STMicroelectronics S.r.l, corresponding to the European patent application EP3912953A1 and the US patent application US210363000A1.

In detail, the MEMS device 50 is formed in a die 51 of semiconductor material, comprising a substrate 52, for example of monocrystalline silicon; an insulating layer 53, on the substrate 52, for example of silicon oxide; a first structural layer 54, on the insulating layer 53, of polycrystalline silicon; and a second structural layer 55, on the first structural layer 54, of polycrystalline silicon.

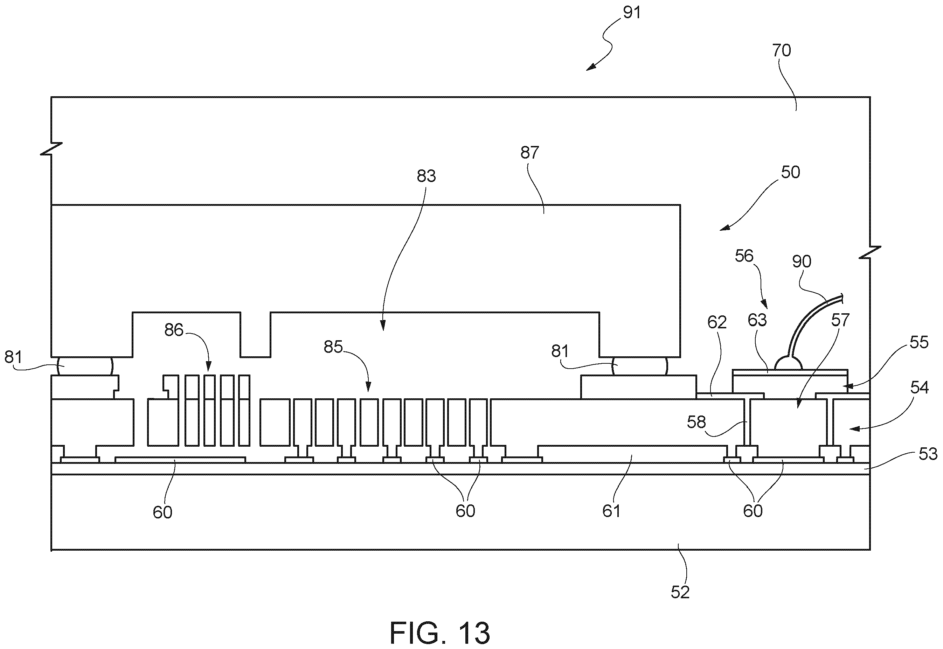

A cap not shown, for example of monocrystalline silicon, may be arranged on and attached to the second structural layer 54 in a zone thereof not visible in Figure 4 (see also the device of Figure 13, where the cap is indicated by 87).

The first and the second structural layers 54, 55 form movable structures and fixed structures, not shown, that form active structures (meaning therewith structures forming MEMS sensors/actuators). In particular, the structural layers 54, 55 form suspended masses, movable electrodes and fixed electrodes of the sensitive portions 2-4 of the inertial device 1 of Figure 1 (see also the device of Figure 13, showing a first and a second sensitive portion 85, 86).

The first structural layer 54 has a greater thickness than the second structural layer 55; for example, the first structural layer 54 may have a thickness comprised between 10 and 60 pm, in particular 20 µm, and the second structural layer 55 may have a thickness comprised between 5 and 20 pm, in particular of 8.4 µm.

The first and the second structural layers 54, 55 also form a fixed peripheral region, including a connection portion 56 similar to the connection portion 19 of Figure 1, wherein connection structures 57 shown in Figure 4 are formed (see also Figure 13).

Each connection structure 57 (also referred to as pad) comprises a lower portion 57A, formed in/by the first structural layer 54, and an upper portion 57B, formed in/by the second structural layer 55.

Each lower portion 57A of the connection structures 57 is surrounded by an annular insulation region 58 of dielectric material, for example of silicon oxide, and are mutually separated by intermediate portions 59, also formed in/by the first structural layer 54. The intermediate portions 59 are therefore arranged between pairs of adjacent connection structures 57.

The intermediate portions 59 are coupled here to the electrical ground of the device 50.

Conductive regions 60, for example of doped polycrystalline silicon, extend above the insulating layer 53 and below the first structural layer 54, locally insulated therefrom by insulation portions 61.

The conductive regions 60 are formed in a single layer and comprise here contact regions 60A, shielding regions 60B, first and second conductive tracks 60C' and 60C".

The contact regions 60A are arranged below and in direct electrical contact with the lower portions 57A of the connection structures 57 at first contact areas 65.

The contact regions 60A are formed in continuity and therefore electrically connected to the first conductive tracks 60C', as visible in Figure 5.

The first conductive tracks 60C', shown schematically in Figure 4 by dashed lines, are connected to respective active structures (not shown) of the MEMS device 50, for example to suspended masses, rotors, movable electrodes or fixed electrodes of the sensitive portions (for example 85, 86 in Figure 13) and therefore form, with the connection structures 57, electrical connections of the active or MEMS structures 50 of the MEMS device 50 with the outside.

The shielding regions 60B are arranged below and in direct electrical contact with the intermediate portions 59 of the first structural layer 54 at second contact areas 66 and are therefore also grounded. Furthermore, the shielding regions 60B are formed in continuity with and therefore electrically connected to the second conductive tracks 60C", as visible in Figure 5.

The second conductive tracks 60C", shown schematically by dashed lines in Figure 4, are coupled with the parts connected to ground of the MEMS device 50 (for example, to the non-biased movable or fixed electrodes through the contact structures 57).

Furthermore, one of the contact structures 57 might allow the ground of the device to be provided to the outside.

The shielding regions 60B surround at a distance the contact regions 60A and are insulated therefrom by some of the insulation portions 61.

The shielding regions 60B here have an open annular shape for the passage of the first conductive tracks 60C', as shown in Figure 5.

The shielding regions 60B are therefore electrically insulated with respect to the contact regions 60A and the first conductive tracks 60C' and shield the contact regions 60A, avoiding or at least limiting parasitic effects and leakage.

For example, the insulation portions 61 may be part of a sacrificial insulation layer, interrupted at the first and the second contact areas 65, 66.

An embodiment of the conductive regions 60 is shown in Figure 5, wherein the lower portions 57A of the connection structures 57 are not shown. In particular, Figure 5 shows the contact areas 65, 66, as well as the annular insulation region 58, and, with a dashed line, the boundaries of the contact regions 60A and the shielding regions 60B and part of the first and the second conductive tracks 60C' and 60C".

With reference again to Figure 4, the insulation layer forming the insulation portions 61 may be a first sacrificial layer used, during the manufacture of the MEMS device 50, for freeing suspended structures, as discussed in the aforementioned Italian patent 102020000011755 (removed for example in the sensitive portions 85 and 86 of Figure 13).

A passivation layer 62 extends above the first structural layer 54.

Furthermore, here, the passivation layer 62 also extends, in part, between the lower portion 57A and the upper portion 57B of each connection structure 57, as represented with a dashed line in Figure 6, indicating the edge of an opening 88 of the passivation layer 62, wherein the first and the second structural layers 54, 55 are in direct contact.

In Figure 4, the portions of the passivation layer 62 which extend between the lower portion 57A and the upper portion 57B of each connection structure 57 are indicated by 62A and contribute to preventing water or humidity droplets from reaching critical zones of the contact structures 57, as explained hereinbelow.

Soldering or welding regions 63, typically of metal such as aluminum Al, gold Au, copper Cu or aluminium-copper AlCu, extend above each connection structure 57, in direct contact with the upper portions 57B of the connection structures 57.

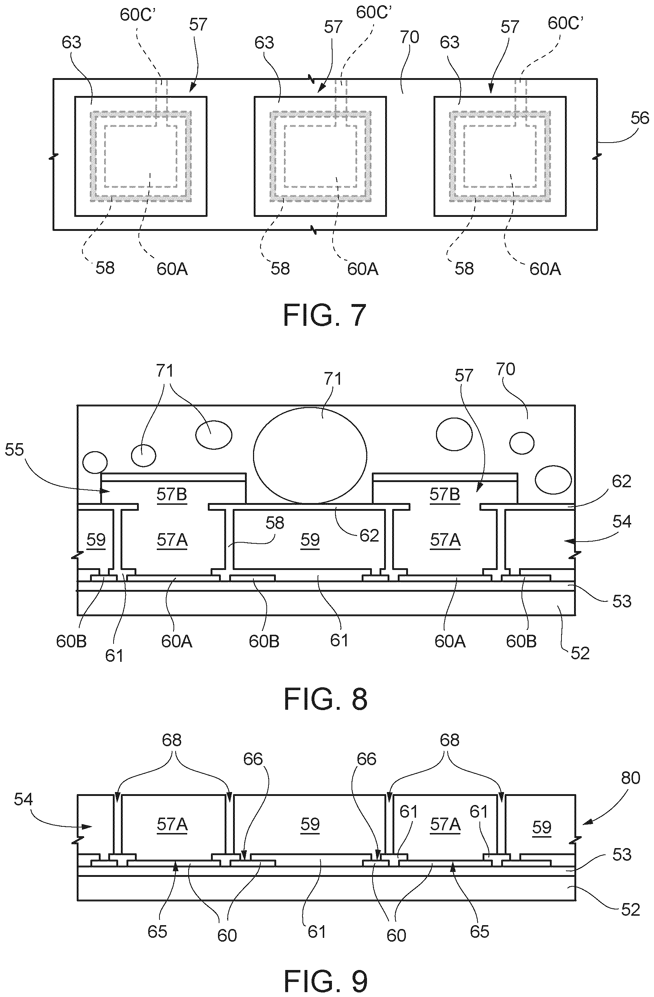

The upper portions 57B of the connection structures 57 are mutually spaced, as also visible in the top-view of Figure 7, showing a plurality of connection structures 57 and wherein, for ease of illustration, only the soldering regions 63 are shown with solid lines and the annular insulation regions 58, the contact regions 60A and the first conductive tracks 60C' of some connection structures 57 are shown with dashed lines.

When the MEMS device 50 is packaged, some packaging material 70 is molded, covers the connection structures 57 and fills the space between the upper portions 57B of the connection structures 57.

In this situation, with reference to Figure 8, due to the reduced height of the second structural layer 55 and therefore of the upper portions 57B of the connection structures 57, compared to the structure of Figures 2, 3A and 3B, it is less likely that air or gas bubbles 71, even of large dimensions, may touch two adjacent connection structures 57.

In any case, any humidity that penetrates the packaging material 70 and infiltrates under the bubble 71 formed between two upper portions 57B, cannot reach the conductive regions 60, due to the height of the first structural layer 54.

In addition, the passivation layer 62, the annular insulation regions 58 and the insulation portions 61 form, as a whole, a tortuous, humidity stopping path.

Furthermore, the lower height of the upper portions 57B with respect to the lower portions 57A of the connection structures 57 causes the facing area of the upper portions 57B to be smaller with respect to that of the lower portions 57A, reducing the risk of electrical connection in case of humidity.

The intermediate regions 59 arranged between adjacent connection structures 57, that are grounded, form spacers which electrically separate the connection structures 57 from each other, avoiding parasitic couplings for most of their height and thus allowing to be placed very close to each other.

Furthermore, the intermediate regions 59 avoid, during the packaging steps, an incomplete resin filling between the contact pads and therefore, as explained above, possible leakage between the contact pads in presence of humidity.

For example, in this manner the connection structures 57 may be arranged so that their upper portions 57B and/or their lower portions 57A are distant at least 20 pm.

The MEMS device 50 may be formed as shown in Figures 9-12.

Figure 9 shows a first wafer 80 of semiconductor material already subject to initial processing steps, as described in aforementioned Italian patent 102020000011755.

In particular, the first wafer 80 comprises the substrate 52, having the insulating layer 53 already formed thereon, for example thermally grown or deposited.

The conductive regions 60 have been formed on the insulating layer 53, for example by deposition of a doped polycrystalline silicon layer and subsequent photolithographic definition.

A first sacrificial layer (intended to form the insulation portions 61) of, for example, silicon oxide has been deposited and patterned above the conductive regions 60. The first sacrificial layer has been selectively removed above the conductive structures 60, where the contact areas 65, 66 are to be grown, as well as any other anchoring and electrical and/or mechanical connection portions where the electrical/mechanical connection is desired between the active structures of the MEMS device 50, formed in the first structural layer 54, and the substrate 50. In this step, the insulation portions 61 are therefore defined.

Furthermore, using an epitaxial growth process, the first structural layer 54 has already been grown, forming the contact areas 65, 66.

In Figure 9, the first structural layer 54 has already been etched, for example by dry etching, in the zones where for example the sensitive portions 85, 86 of Figure 13 are desired to be formed, forming trenches 68 which extend throughout the first structural layer 54 and define, *i.a.,* the lower portions 57A of the connection structures 57 and the intermediate portions 59.

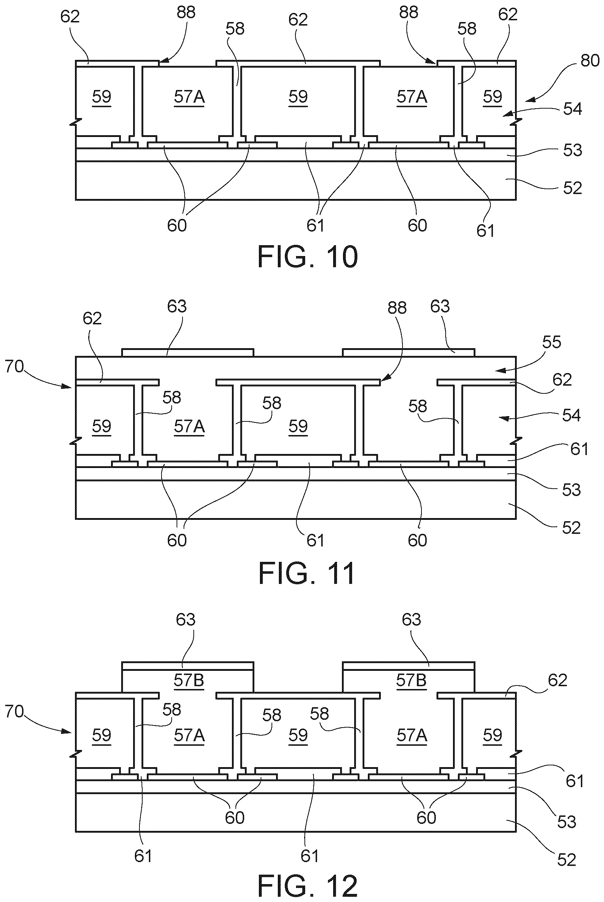

In Figure 10, a second sacrificial layer is deposited, forming also the passivation layer 62. The second sacrificial layer/passivation layer 62 is, for example, of TEOS (TetraEthylOrthoSilicate) having a thickness comprised, for example, between 0.1 µm and 5 µm. The second sacrificial layer/passivation layer 62 fills the trenches 68, forming, *i.a.,* the annular insulation regions 58, is planarized and selectively removed, forming the passivation layer 62 and the openings 88.

Then, Figure 11, the second structural layer 55 is grown above the first structural layer 54 and the passivation layer 62. The second structural layer 54 is grown epitaxially and planarized, for example by CMP (Chemical Mechanical Polishing) so that, where the passivation layer 62 is not present (for example at the openings 88 in the connection portion 56), a structural layer is formed having a thickness equal to the sum of the thicknesses of the first and the second structural layers 54, 55.

Then, the soldering regions 63, for example of AlCu, are formed.

The soldering regions 63 may be formed by depositing and patterning a metal layer.

Then, in a manner not shown, the active structures of the MEMS device 50 formed by the sole second structural layer 55 or by both structural layers 54, 55 are defined, in particular for defining movable masses and fixed and movable electrodes of the sensitive portions 85, 96 of Figure 13.

Subsequently, also in a manner not shown, the movable structures are released through selective removal of the first sacrificial layer 61, in a non-visible manner.

Then, a cap wafer is attached to the first wafer 80 through bonding regions 81 (Figure 13); the first wafer 80 may be thinned, for example by lapping, so as to have a desired thickness; the cap wafer is cut, for example by dry etching, to open a window above the connection portion 56. In this step, Figure 12, again through a dry etching and using the soldering regions 63 as a mask, the second structural layer 55 is defined to form the upper portions 57B of the connection structures 57.

Subsequently, the overall wafer is diced to form the inertial MEMS device 50.

An example of inertial MEMS device 50 thus obtainable is shown in Figure 13, showing the connection portion 56 and an active portion 83 accommodating the first and the second sensitive portions 85, 86, similar to the sensitive portions 2 and 3 of Figure 1. Here, the first sensitive portion 85 is formed by the sole first structural layer 54 and the second sensitive portion 86 is formed by both structural layers 54, 55, but other active structures (meaning by this term structures forming MEMS sensors/actuators) might be formed in the sole second structural layer 55.

In detail, Figure 13 shows the substrate 52; the first structural layer 54; the second structural layer 55; the passivation layer 62; the conductive regions 60; and the cap 87, covering the sensitive portions 85, 86 and bonded to the second structural layer 55.

Also shown in Figure 13 is a wire 90, soldered to one of the connection structures 57, and part of the packaging material 70, forming a packaged device 91.

Finally, it is clear that modifications and variations may be made to the device and the manufacturing process described and illustrated herein without thereby departing from the scope of the present invention, as defined in the attached claims.

For example, although the description specifically refers to an inertial MEMS device, the described solution also applies to other types of MEMS devices provided with connection regions that may be reached, during use, by humidity and water droplets and might modify the electrical parameters of the same device in an undesired manner.

The shielding regions 60B may be missing.

The openings 88 above the lower portions 57A of the connection structures 57 (see for example Figure 10) may have a greater area than shown, for example approximately equal to that of the lower portions 57A, while maintaining electrical insulation between the upper portions 57B and the intermediate portions 59.

## Claims

1. A MEMS device (50) comprising:
a substrate (52) of semiconductor material;
a first structural layer (54) of semiconductor material, superimposed on the substrate (52) and having a first thickness;
a second structural layer (55) of semiconductor material, superimposed on the first structural layer (54) and having a second thickness;
an active portion (83), accommodating active structures (85, 86) formed in the first structural layer (54) and/or in the second structural layer (55);
a connection portion (56), accommodating a plurality of connection structures (57) and arranged laterally to the active portion (85, 86); and
a plurality of conductive regions (60), arranged above the substrate (52) and extending between the active portion (85, 86) and the connection portion (56),
wherein each connection structure (57) comprises:
a first connection portion (57A), in electrical contact with a respective conductive region (60A) of the plurality of conductive regions (60) and formed in the first structural layer (54); and
a second connection portion (57B), on the first connection portion (57A) and in electrical continuity therewith, the second connection portion (57) formed in the second structural layer (55);
the first connection portion (57A) having a greater thickness than the second connection portion (57B).

2. The MEMS device according to the preceding claim, wherein the first connection portions (57A) of each connection structure (57) are surrounded by respective annular insulation regions (58) of dielectric material, wherein the annular insulation regions (58) have a height equal to the first thickness.

3. The MEMS device according to the preceding claim, wherein intermediate regions (59), formed in the first structural layer (54), extend between adjacent connection structures (57), and are electrically insulated with respect to the connection structures (57) by the annular insulation regions (58).

4. The MEMS device according to the preceding claim, wherein the intermediate regions (59) are coupled to a reference potential line (60C").

5. The MEMS device according to claim 3 or 4, wherein the conductive regions (60) comprise contact regions (60A) in direct electrical contact with the connection structures (57); shielding regions (60B) in direct electrical contact with the intermediate regions (59) and conductive tracks (60C', 60C") electrically coupling the connection structures (57) and the intermediate regions (59) with the active structures (85, 86) in the active portion (83).

6. The MEMS device according to the preceding claim, wherein the shielding regions (60B) surround at a distance respective contact regions (60A).

7. The MEMS device according to any of claims 2-6, wherein a passivation layer (62) of dielectric material extends locally on the first structural layer (54) and partially between the first and the second connection portions (57A, 57B) of the connection structures (57) and is in direct contact with the annular insulation regions (58).

8. The MEMS device according to any of the preceding claims, wherein the first thickness is comprised between 10 and 60 µm and the second thickness is comprised between 5 and 20 pm.

9. The MEMS device according to any of the preceding claims, further comprising a metal region (63) superimposed on the second connection portion (57B).

10. A packaged device (91) comprising the MEMS device (50) according to any of the preceding claims, further comprising a packaging material (70) covering the connection structures (57) and extending between the second connection portions (57B).

11. A process for manufacturing a MEMS device according to any of claims 1-10, comprising:
forming a plurality of conductive regions (60) on a substrate (52) of semiconductor material;
forming a first structural layer (54) of semiconductor material (60), the first structural layer (54) having a first thickness;
selectively removing the first structural layer (54), forming first connection portions (57A) on and in contact with at least some conductive regions (60);
forming a second structural layer (55) of semiconductor material on the first structural layer (54), the second structural layer (55) having a second thickness and being in direct contact with the first connection portions (57A); and
selectively removing the second structural layer (55) forming second connection portions (57B),
wherein selectively removing the first structural layer (54) and/or the second structural layer (55) comprises defining active regions in an active portion of the MEMS device, and
the first connection portion (57A) has a greater thickness than the second connection portion (57B).

12. The process according to the preceding claim, further comprising, before forming a second structural layer (55) :
forming trenches (68) in the first structural layer (54), the trenches laterally delimiting the first connection portions (57A);
filling the trenches (68) with dielectric material, forming annular insulation regions (58) surrounding the first connection portions (57A);
forming a passivation layer (62) of dielectric material on the first structural layer (54); and
partially removing the passivation layer to form openings (88) above the first connection portions (57A) of the connection structures (57).

13. The process according to claim 11 or 12, wherein selectively removing the second structural layer (55) comprises forming, on the second structural layer (54), metal regions (63) vertically aligned to the first connection portions (57A) and removing the second structural layer (55) where exposed.

14. The process according to any of claims 11-13, wherein forming a plurality of conductive regions (60) comprises:
forming contact regions (60A) below and in electrical contact with the connection structures (57);
forming shielding regions (60B) below and in electrical contact with intermediate regions (59) of the first structural layer, the intermediate regions (59) being interposed between adjacent connection structures (57); and
forming conductive tracks (60C', 60C") electrically coupling the connection structures (57) and the intermediate regions (59) with the active regions.
